# EUROPÄISCHE PATENTSCHRIFT

(11) **EP 2 493 077 B1**
(45) Veröffentlichungstag und Bekanntmachung des Hinweises auf die Patenterteilung: **28.09.2016**
(21) Anmeldenummer: 11401031.7
(22) Anmeldetag: 24.02.2011
(51) Int. Cl.: H03K 17/96, G06F 3/044

(54) **Bedienvorrichtung für ein Haushaltgerät**
Operating device for a domestic appliance
Dispositif de commande d'un appareil ménager

(43) Veröffentlichungstag der Anmeldung: 29.08.2012
(73) Patentinhaber: Miele & Cie. KG, 33332 Gütersloh (DE)
(72) Erfinder: Banmann, Johann, 33334 Gütersloh (DE); Schneider, Daniel, 33415 Verl (DE)

(56) Entgegenhaltungen:
- WO-A2-2007/024486
- JP-A- 2010 039 537
- US-A1- 2004 119 701

## Beschreibung

Die Erfindung betrifft eine Bedienvorrichtung für ein Haushaltgerät die eine als Berührschirm ausgebildete Blende umfasst, mit einem Display, einem transparenten Sensorfeld, mit einer ersten leitende Schicht mit einer Struktur von sensitiven, zumindest im Wesentlichen geraden Linien, die jeweils mehrere, miteinander leitend verbundene Flächenelemente umfassen und einer zweiten leitenden Schicht mit einer Struktur von sensitiven, zumindest im Wesentlichen geraden Linien, die sich quer zu den Linien der ersten Schicht erstrecken, mit jeweils mehreren, miteinander leitend verbundenen Flächenelementen, wobei an den einzelnen Linien an zumindest einem Rand des Sensorfeldes Leitungen zur Verbindung mit einem Microcontroller zur Bestimmung einer Berührposition auf dem Sensorfeld angebracht sind.

Eine als Berührschirm ausgebildete Bedienvorrichtung ist aus der WO 2007/024486 A2 bekannt. Hierbei ist eine Struktur von sensitiven, geraden Linien mit rautenförmigen Flächenelementen auf einer Schicht vorgesehen. Auf einer darunter liegenden Schicht sind ebenfalls rautenförmige Flächenelemente angeordnet, die jeweils benachbart zu den oberen Flächenelementen angeordnet sind.

Eine als Berührschirm ausgebildete Bedienvorrichtung ist aus der der US 2004/119701 A1 bekannt. Diese umfasst zwei Schichten mit parallelen leitfähigen Reihen diamantförmiger oder hexagonaler Flächenelemente, die mit schmalen rechteckigen Streifen verbunden sind. Die Reihen der jeweiligen Schichten sind orthogonal zueinander und die schmalen Streifen der jeweiligen Schichten liegen übereinander.

Aus der EP 1 894 712 A1 ist eine Bedienvorrichtung für einen Backofen bekannt, der einen Schichtaufbau aus einem Träger und darauf angeordneten, voneinander isolierten leitenden Schichten umfasst. Der Träger mit seinen Schichten ist wiederrum an der Unterseite einer Glasplatte angebracht, sodass die Glasplatte auf der Oberseite die Berührseite darstellt.

Die bekannten Bedienvorrichtungen haben den Nachteil, dass eine hinreichende Genauigkeit der Berührposition nicht mehr gegeben ist, wenn die Blende sehr dick oder stark ausgebildet ist oder bei einer als Glasplatte ausgeführten Blende. Ferner kann es vorkommen, dass eine Berührung aufgrund des durch die Stärke der Blende bedingen Abstandes zu keiner Sensierung kommt, wenn die Blende berührt wird.

Der Erfindung liegt somit die Aufgabe zugrunde, eine Bedienvorrichtung für ein Haushaltgerät bereitzustellen, die bei einfachem Aufbau eine zuverlässige und genaue Sensierung der Berührposition bereitstellt.

Erfindungsgemäß wird diese Aufgabe durch eine Bedienvorrichtung mit den Merkmalen des Patentanspruchs 1 sowie mit einem Haushaltgerät nach Anspruch 7 und einem Küchengerät nach Anspruch 9 gelöst. Vorteilhafte Ausgestaltungen und Weiterbildungen der Erfindung ergeben sich aus den jeweils nachfolgenden abhängigen Ansprüchen.

Die mit der Erfindung erreichbaren Vorteile bestehen darin, dass in der Bedienblende mit einem einfachen Mikrocontroller sehr zuverlässig die genaue Position einer Berührung auf der Blende erkannt wird. Zuverlässig bedeutet, dass im rauen Haushaltsbetrieb mit den dort auftretenden Verschmutzungen oder Feuchtigkeitsbildung durch Taubelag keine Fehlbedienungen oder Fehlschaltungen vorkommen. Hierzu ist die Struktur der Zeilen und die Struktur der Spalten der beiden übereinander liegenden Schichten derart ausgebildet, dass die Flächenelemente der ersten Schicht und die Flächenelemente der zweiten Schicht in ihrem betriebsgemäßen Verbund nebeneinander unter Bildung eines Abstandes zueinander liegen. Ferner weisen die einzelnen Flächenelemente jeweils eine quadratische oder rautenförmige Grundform mit gekrümmten, S-förmig ausgebildeten Seitenlinien der Umrandung auf. Dadurch werden in den Randbereichen unterschiedliche Kapazitätsänderungen bewirkt, wodurch sehr genau und eindeutig die Berührposition ermitteln lässt. Insgesamt ist sichergestellt, dass durch den Mikrocontroller erfasste Kapazitätsänderungen oder Widerstandsänderungen eindeutig einer eng begrenzten Fläche auf der Blende zugeordnet werden kann, die dann als Berührfläche identifiziert wird. Ferner wird eine eindeutig zuordenbare Signaländerung der elektrischen Größe auch bei einer dicken Blende, beispielsweise einer 3 bis 8 mm dicken Glasplatte oder Kunststoffplatte, erreicht. Dabei erfolgt die Auswertung in einem Digital-Analog-Hybridverfahren, in dem in vorgegebenen Grenzen das Flächenelement mit der stärksten Signalzuordnung identifiziert wird und ferner die Signalstärke der benachbarten Flächen zur Zuordnung des Berührortes berücksichtigt wird. Hierzu ist es vorteilhaft, dass die als leitende Schicht ausgebildeten Flächenelemente dazu ausgebildet sind, eine Änderung einer elektrischen Größe, wie elektrischer Widerstand oder Kapazität bei einer Berührung oder Annäherung an das Sensorfeld zu bewirken.

In einer vorteilhaften Ausführung weist der Abstand eine Breite im Bereich von 0,02 bis 1 mm auf. Dadurch werden Signalverfälschungen durch kapazitive Kopplungen zwischen den benachbarten Flächenelementen vermindert oder vermieden, was zu einer verbesserten Auswertung der elektrischen Größe bzw. der Größenänderung führt. In einer besonderen Weiterbildung hat der Abstand eine Breite im Bereich von 0,02 bis 0,1 mm, wobei der Abstand insgesamt im Wesentlichen konstant ist.

Die in Zeilen angeordneten Flächenelemente der Schicht, die näher zur Blende liegt, sind größer als die Flächenelemente der tiefer liegenden Schicht für die Spalten. Es versteht sich von selbst, dass die beiden Schichten auch vertauscht werden können, sodass dann die Schicht für die Spalten näher an der Blende angeordnet ist. Damit wird die Empfindlichkeit für eine Kapazitätsänderung in der tiefer liegenden Schicht erhöht, wodurch eine Kompensation der Empfindlichkeit erreicht wird.

Hierbei ist ein einzelnes Flächenelement einer Spalte, also dem Flächenelement der tieferen, weiter von der Berührfläche entfernten Schicht, um den Faktor im Bereich von 1,1 bis 1,5 größer ausgebildet als ein einzelnes Flächenelement der Zeile, also dem Flächenelement der näher zur Berührfläche liegenden Schicht.

In einer vorteilhaften Weiterbildung weist ein leitendes Flächenelement einer Zeile, also der näher zur Berührfläche liegenden Schicht eine Größe im Bereich von 30 bis 45 mm^2 und ein leitendes Flächenelement einer Spalte, also ein Flächenelement auf der von der Berührfläche entfernteren Schicht eine Größe im Bereich von 45 bis 55 mm^2 auf. Diese recht großen Flächen lassen zwar eine ungenaue Berührposition vermuten, dies ist jedoch nicht der Fall. Durch die recht großen leitenden Flächenelemente werden stets zuverlässig starke Signaländerungen der elektrischen Größe erzeugt, wenn die Berührfläche mit dem Finger berührt wird. Da aufgrund der hybriden Auswertemethode auch kleinere Signaländerungen, die benachbarten Flächenelementen zugeordnet werden, erfasst werden, können diese Signaländerungen zur genauen Bestimmung der Berührposition eingerechnet werden. Auch Bewegungen der Berührposition, wie es beim sogenannten "Sliden" geschieht, können aufgrund der geringen Anzahl von leitenden Flächen in Verbindung mit den starken Signaländerungen und der Berücksichtigung der jeweils benachbarten Flächen, schnell und sauber erfasst werden.

Die Flächenelemente der ersten Schicht sind gekrümmt in etwa der Form einer gespiegelten Tulpe ausgebildet, und die Flächenelemente der zweiten Schicht korrespondierend zu den Krümmungen der ersten Schicht etwa in der Form eines gespiegelten Herzens ausgebildet. Damit werden deutlich zuordenbare Signale bzw. Signaländerungen bereitgestellt, wenn die Berührposition sich genau im Bereich der Spalte zwischen zwei Flächenelementen befindet oder der Finger auf ein Flächenelement nur teilweise wirkt und auf ein benachbartes Flächenelement nur am Rand wirkt.

In einer vorteilhaften Weiterbildung ist die Blende als Teil des Gehäuses ausgebildet. Damit sind hinsichtlich der Gestaltung des Gerätes kaum Grenzen gesetzt, da in dem als Bedienblende fungierenden Wandbereich keine Schalter oder Drehknebel vorgesehen werden müssen. Insgesamt vereinfacht das den Gehäuseaufbau des Haushaltgerätes und bietet auch hinsichtlich des Designs nahezu keine Einschränkungen.

Die Erfindung betrifft ferner ein Küchengerät, wie Herd, Backofen oder Kühlgerät mit einer Bedienvorrichtung wie vorstehend beschrieben. Die Bedienblende kann hierbei besonders einfach integriert werden und bietet aufgrund ihrer Robustheit gegenüber mechanischen Einwirkungen dauerhaft eine zuverlässige Funktion.

Bei der Verwendung der Bedienvorrichtung in einem Herd oder Backofen ist es zweckmäßig, das Blendenteil durch einen Bereich einer Glasplatte oder eines Ceranfeldes zu bilden.

Ein Ausführungsbeispiel der Erfindung ist in den Zeichnungen rein schematisch dargestellt und wird nachfolgend näher beschrieben. Es zeigen:
- Fig. 1:: ein Haushaltgerät mit einer Bedienvorrichtung in einer perspektivischen Frontansicht;
- Fig. 2:: das Sensorfeld der Bedienvorrichtung;
- Fig. 3, 4:: einen detaillierten Ausschnitt des Sensorfeldes und
- Fig. 5 bis 8:: eine schematische Darstellung des Schichtaufbaus für verschiedene Varianten.

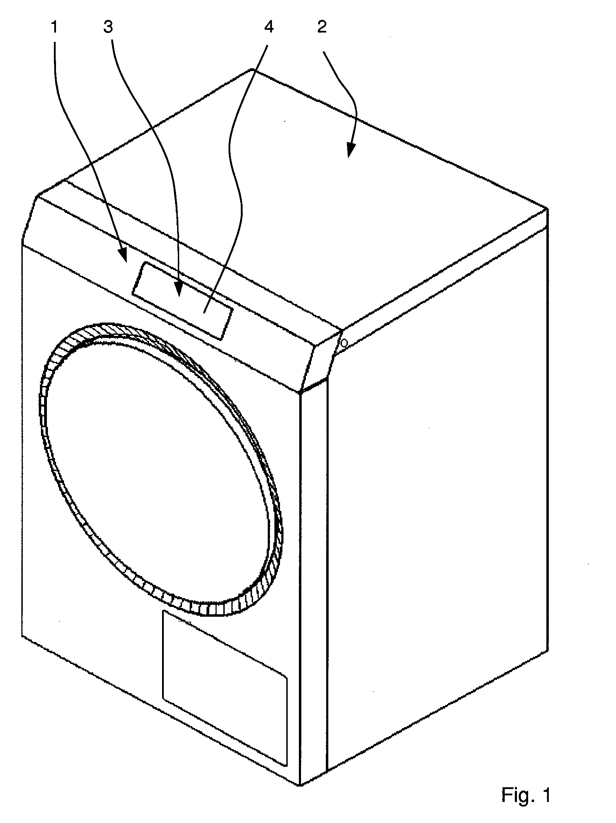

Fig.1 zeigt als Haushaltgerät eine Waschmaschine 2 mit einem Gehäuse 19 in einer perspektivischen Frontansicht. Im oberen Bereich, bezogen auf die betriebsgemäße Aufstellposition des Gerätes 2, ist die Bedienvorrichtung 1 angeordnet. Die Bedienvorrichtung 1 umfasst eine für den Benutzer zugängliche berührempfindliche Blende 3, die ein Sensorfeld 4 für die Einstellung von Programmen und Parametern für einen Mikrocontroller, der als Steuerung fungiert, aufweist. In der Blende 3 ist ferner unterhalb des Sensorfeldes 4 ein Display angeordnet, das zur Anzeige von auswählbaren Programmen oder Parametern oder anderen Informationsanzeigen dient.

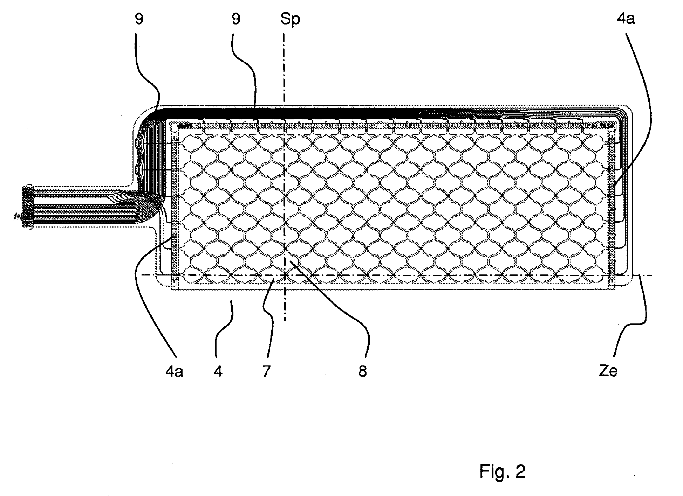

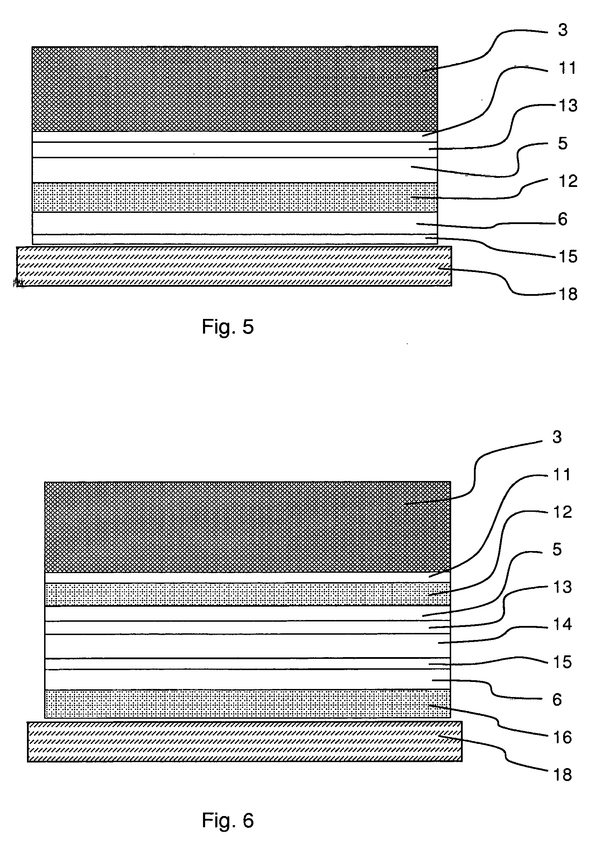

Fig. 2 zeigt das Sensorfeld 4 der Bedienvorrichtung 1. Das Sensorfeld 4 umfasst eine ersten leitende Schicht 5 mit einer Struktur von sensitiven, zumindest im Wesentlichen geraden Linien, die hier als Zeilen Ze bezeichnet werden, die jeweils mehrere, miteinander leitend verbundene Flächenelemente 7 umfassen und einer zweiten leitenden Schicht 6 mit einer Struktur von sensitiven, zumindest im Wesentlichen geraden Linien, hier Spalten SP, die sich quer zu den Linien Ze der ersten Schicht 5 erstrecken. Entlang der Spalten Sp sind jeweils mehrere, miteinander leitend verbundene Flächenelementen 8 angebracht. An den einzelnen Linien Ze, Sp sind an zumindest einem Rand 4a des Sensorfeldes 4 Leitungen 9 zur Verbindung mit einem Microcontroller (nicht dargestellt) zur Bestimmung einer Berührposition auf dem Sensorfeld 4 angebracht. Die Struktur der Zeilen Ze und die Struktur der Spalten Sp der beiden übereinander liegenden Schichten 5, 6 ist dabei derart ausgebildet, dass die Flächenelemente 7 der ersten Schicht 5 und die Flächenelemente 8 der zweiten Schicht 6 in ihrem betriebsgemäßen Verbund nebeneinander unter Bildung eines Abstandes (A) zueinander liegen. Die Schichten 5, 6 können auf Folien 15, 16 (Fig. 5 bis 8) oder Glas aufgebracht sein, die miteinander unter Bereitstellung einer Isolation und/oder eines Dielektrikums verklebt sind. Das so erstellte Sensorfeld 4 wird auf der Innenseite einer Blende 3 angepresst oder verklebt, mit einem transparenten Klebemittel 11 (Fig. 5 bis 8).

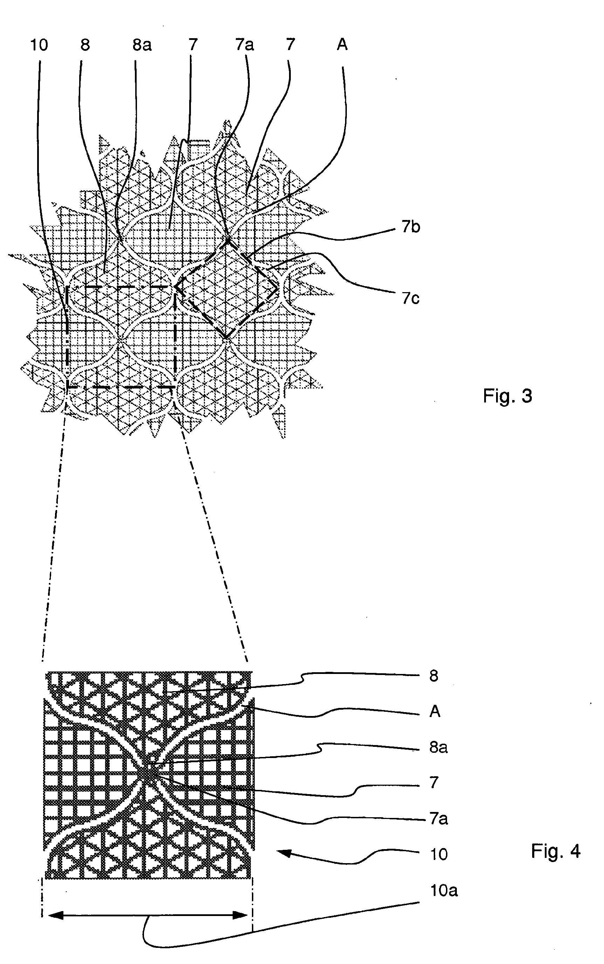

Fig. 3 zeigt einen vergrößerten Ausschnitt des Sensorfeldes 4. Hier ist zu erkennen, dass die einzelnen Flächenelemente 7, 8 jeweils eine quadratische oder rautenförmige Grundform 7b mit gekrümmten, S-förmig ausgebildeten Seitenlinien 7c der Umrandung des jeweiligen Flächenelements 7, 8 aufweisen. Die Ausführung der Krümmungen ist derart gewählt, dass die Flächenelemente 8 der zweiten Schicht 6, hier der Spalten, jeweils die Form eines gespiegelten Herzens bilden, dessen Spitzen 8a in Verlaufsrichtung für die Spalten SP zeigen. Die Spitzen 8a der einzelnen Flächenelemente 8 der Spalte SP sind miteinander leitend verbunden. Anders ausgedrückt, es ergibt sich ein Streifen mit wellenförmigen Rändern, bei dem der bauchige Bereich, der das Flächenelement 8 bildet, in einen taillierten Bereich übergeht. In den taillierten Bereichen sind die Flächenelemente 7 der ersten Schicht 5 platziert, die etwa eine gespiegelte Tulpenform aufweisen und so den gekrümmten Raum des taillierten Bereichs unter Bildung eines etwa konstanten Abstandes A ausfüllen. Die Stielseiten 7a der Tulpen sind miteinander leiten verbunden in Verlaufsrichtung Ze der Zeilen.

Ein Ausschnitt gemäß Fig. 4 skizziert ein sogenanntes in etwa quadratisches Strukturelement 10, das ein Maß für das Raster der Sensorelemente aufzeigt. In einer vorteilhaften Ausführung hat das Strukturelement eine Länge oder Breite im Bereich von 6 bis 14 mm. In der gezeigten Ausführung beträgt die Seitenlänge 10a etwa 10 mm. In dieser Ausführung beträgt die Fläche der Anteils der Flächenelemente 7 für die Zeilen Ze etwa 38,24 mm^2 und die Fläche der Anteils der Flächenelemente 8 für die Spalten Sp etwa 48, 73 mm^2. Es ist insgesamt vorteilhaft, dass die leitenden Flächenelemente 7 einer Zeile Ze jeweils eine Größe im Bereich von 30 bis 45 mm^2 und die leitenden Flächenelemente 8 einer Spalte Sp eine Größe im Bereich von 45 bis 55 mm^2.

Der Schichtaufbau der als Touchscreen-Sensor aufgebauten Bedienvorrichtung 1 incl. Geräteblende 3 kann unterschiedlich ausgeführt werden. Fig. 5 bis 8 zeigen zweckmäßige Ausführungen in einer skizzierten Schnittdarstellung der Bedienvorrichtung 1.

Bei der Variante gemäß Fig. 5 sind die Schichten der Aufbau in folgender Reihenfolge von der Blende ausgehend zum Geräteinneren hin.
- Blende 3;
- Kleberschicht 11 beispielsweise optical clear adhestive (OCA);
- Schutzschicht 13;
- erste Schicht 5 aus elektrisch transparenten leitendem Material, wie ITO;
- Träger 12 für die erste Schicht 5 und für die zweite Schicht 6, wie Folie oder Glas;
- zweite Schicht 6 aus elektrisch transparenten leitendem Material, wie ITO;
- Schutzschicht 13.

Der Träger 12 stellt bei dieser Variante auch das Dielektrikum dar.

Die Variante gemäß Fig. 6 ist wie folgt aufgebaut, in der nachfolgend genannten Reihenfolge:
- Blende 3;
- Kleberschicht 11, beispielsweise optical clear adhestive (OCA);
- Träger 12 für die erste Schicht, wie Folie oder Glas;
- erste Schicht 5 aus elektrisch transparenten leitendem Material, wie ITO;
- Schutzschicht 13
- Dielektrikum 14, beispielsweise aus Klebstoff
- Schutzschicht 15
- zweite Schicht 6 aus elektrisch transparenten leitendem Material, wie ITO;
- Träger 16 für die zweite Schicht.

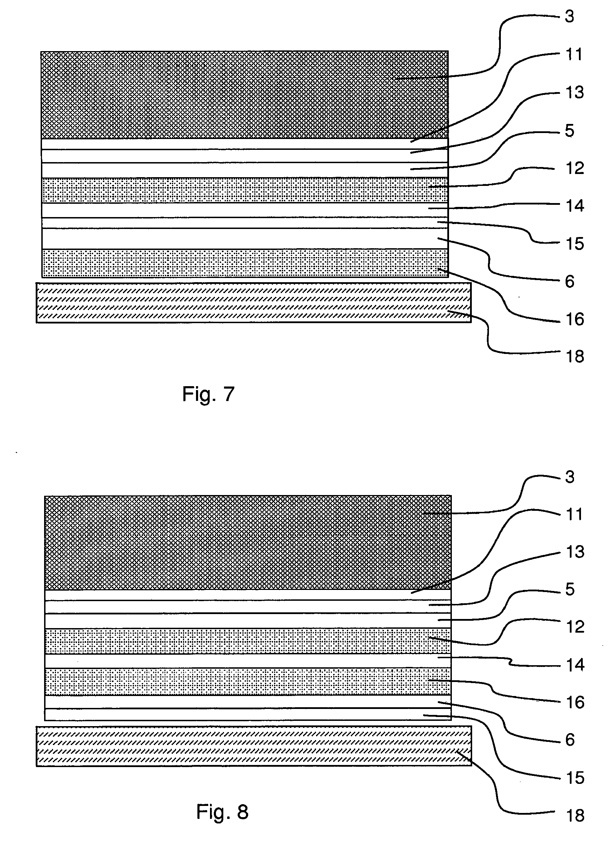

Die Variante gemäß Fig. 7 ist wie folgt aufgebaut, in der nachfolgend genannten Reihenfolge:
- Blende 3;
- Kleberschicht 11, beispielsweise optical clear adhestive (OCA);
- Schutzschicht 13
- erste Schicht 5 aus elektrisch transparenten leitendem Material, wie ITO;
- Träger 12 für die erste Schicht, wie Folie oder Glas;
- Dielektrikum 14, beispielsweise aus Kleberstoff
- Schutzschicht 15
- zweite Schicht 6 aus elektrisch transparenten leitendem Material, wie ITO;
- Träger 16 für die zweite Schicht.

Die Variante gemäß Fig. 8 ist wie folgt aufgebaut, in der nachfolgend genannten Reihenfolge:
- Blende 3;
- Kleberschicht 11, beispielsweise optical clear adhestive (OCA);
- Schutzschicht 13
- erste Schicht 5 aus elektrisch transparenten leitendem Material, wie ITO;
- Träger 12 für die erste Schicht 5, wie Folie oder Glas;
- Dielektrikum 14, beispielsweise aus Klebstoff
- Träger 16 für die zweite Schicht 6
- zweite Schicht 6 aus elektrisch transparenten leitendem Material, wie ITO;
- Schutzschicht 15.

Für alle Varianten kann je optional eine der Schutzschichten 13, 15 oder beide Schutzschichten 13, 15 weggelassen werden, wenn der Schutz und die Funktion der elektrisch leitenden Schichten 5, 6 im Zusammenspiel mit dem Dielektrikum 14 durch die Ausbildung der anderen Schichten gewährleistet ist. Bei allen skizzierten Varianten ist das Display 18 unterhalb der letzten Schicht im Inneren der Bedienvorrichtung 1 bzw. im Geräteinneren angeordnet.

## Patentansprüche

1. Bedienvorrichtung (1) für ein Haushaltgerät (2), die eine als Berührschirm ausgebildete Blende (3) umfasst, mit einem Display, einem transparenten Sensorfeld (4) mit einer ersten leitenden Schicht (5) mit einer Struktur von zumindest im Wesentlichen geraden Zeilen (Ze), die jeweils mehrere, miteinander leitend verbundene Flächenelemente (7) umfassen und einer zweiten leitenden Schicht (6) mit einer Struktur von zumindest im Wesentlichen geraden Spalten (Sp), die sich quer zu den Zeilen (Ze) der ersten Schicht (5) erstrecken, mit jeweils mehreren, miteinander leitend verbundenen Flächenelementen (8), wobei an den einzelnen Zeilen und Spalten (Ze, Sp) an zumindest einem Rand (4a) des Sensorfeldes (4) Leitungen (9) zur Verbindung mit einem Microcontroller zur Bestimmung einer Berührposition auf der Blende (3) angebracht sind,
wobei die Struktur der Zeilen (Ze) und die Struktur der Spalten (Sp) der beiden übereinander liegenden Schichten (5, 6) derart ausgebildet ist, dass die Flächenelemente (7) der ersten Schicht (5) in Richtung der Schichten (5, 6) neben den Flächenelementen (8) der zweiten Schicht (6) liegen, unter Bildung eines im Wesentlichen gleichmäßigen Abstandes (A) in Richtung der Schichten (5, 6) benachbarter Flächenelemente zueinander,
**dadurch gekennzeichnet,**
**dass** die einzelnen Flächenelemente (7) jeweils eine quadratische oder rautenförmige Grundform (7b) mit gekrümmten, S-förmig ausgebildeten Seitenlinien (7c) der Umrandung aufweisen, wobei die Flächenelemente (8) der zweiten Schicht (6) jeweils die Form eines gespiegelten Herzens bilden, dessen Spitzen (8a) in Verlaufsrichtung der Spalten (Sp) zeigen und die Flächenelemente (7) der ersten Schicht (5) eine gespiegelte Tulpenform aufweisen, deren Stielseiten (7a) in Verlaufsrichtung der Zeilen (Ze) zeigen, und
**dass** die in Zeilen angeordneten Flächenelemente (7) der Schicht (5), die näher zur Blende (3) liegt, kleiner sind als die Flächenelemente (8) der tiefer liegenden Schicht (6) für die Spalten (Sp), wobei ein einzelnes Flächenelement (8) einer Spalte (Sp) um den Faktor im Bereich von 1,1 bis 1,5 größer ist als ein einzelnes Flächenelement (7) einer Zeile (Ze).

2. Bedienvorrichtung (1) nach Anspruch 1, wobei die in den leitenden Schichten (5, 6) ausgebildeten Flächenelemente (7, 8) dazu ausgebildet sind, eine Änderung einer elektrischen Größe, wie elektrischer Widerstand oder Kapazität bei einer Berührung oder Annäherung an der Blende (3) zu bewirken.

3. Bedienvorrichtung (1) nach Anspruch 1,
wobei der Abstand (A) eine Breite im Bereich von 0,02 bis 1 mm aufweist.

4. Bedienvorrichtung (1) nach einem der Ansprüche 1 bis 3,
wobei ein leitendes Flächenelement (7) einer Zeile (Ze) eine Größe im Bereich von 30 bis 45 mm^2 und ein leitendes Flächenelement (8) einer Spalte (Sp) eine Größe im Bereich von 45 bis 55 mm^2 aufweist.

5. Bedienvorrichtung (1) nach einem der Ansprüche 1 bis 4,
wobei die Flächenelemente (7) der ersten Schicht (5) gekrümmt in etwa der Form einer gespiegelten Tulpe ausgebildet sind, und dass die Flächenelemente (8) der zweiten Schicht (6) korrespondierend zu den Krümmungen der ersten Schicht (5) etwa in der Form eines gespiegelten Herzens ausgebildet sind.

6. Bedienvorrichtung (1) nach einem der Ansprüche 1 bis 5,
**dadurch gekennzeichnet,**
**dass** die Blende (3) aus Glas oder einem transparenten Kunststoff besteht.

7. Wasserführendes Haushaltgerät (2), wie Waschmaschine, Trockner, Waschtrockner oder Geschirrspüler, mit einem Gehäuse (17) mit einer Bedienvorrichtung (1) nach einem der Ansprüche 1 bis 6.

8. Wasserführendes Haushaltgerät (2) nach Anspruch 7
**dadurch gekennzeichnet,**
**dass** die Blende (3) als Teil des Gehäuses (17) ausgebildet ist.

9. Küchengerät, wie Herd, Backofen oder Kühlgerät, mit einer Bedienvorrichtung (1) nach einem der Ansprüche 1 bis 6.

10. Herd nach Anspruch 9, umfassend eine Glasplatte oder ein Ceranfeld,
wobei das Blendenteil (3) durch einen Bereich der Glasplatte oder des Ceranfeldes gebildet ist.

## Claims

1. Operating device (1) for a domestic appliance (2), comprising a panel (3) that is formed as a touchscreen and comprises a display, a transparent sensor field (4) having a first conductive layer (5) that has a structure made up of at least substantially straight rows (Ze), each of which rows comprises a plurality of conductively interconnected surface elements (7), and having a second conductive layer (6) that has a structure made up of at least substantially straight columns (Sp), which columns extend transversely to the rows (Ze) of the first layer (5) and each comprise a plurality of conductively interconnected surface elements (8), lines (9) for connection to a microcontroller being attached to the individual rows and columns (Ze, Sp) at at least one edge (4a) of the sensor field (4) in order to determine a touch position on the panel (3), the structure of the rows (Ze) and the structure of the columns (Sp) of the two layers (5, 6) placed one on top of the other being designed such that the surface elements (7) of the first layer (5) are located next to the surface elements (8) of the second layer (6) in the direction of the layers (5, 6), forming a substantially equal spacing (A) between adjacent surface elements in the direction of the layers (5, 6),
**characterised in that**
the individual surface elements (7) each have a square or rhombic basic shape (7b) having curved, S-shaped edge lines (7c) of the border, the surface elements (8) of the second layer (6) each forming the shape of a mirrored heart, the tips (8a) of which point in the extension direction of the columns (Sp), and the surface elements (7) of the first layer (5) having a mirrored tulip shape, the stem ends (7a) of which point in the extension direction of the rows (Ze), and
**in that** the surface elements (7), which are arranged in rows, of the layer (5) that is closer to the panel (3) are smaller than the surface elements (8) of the lower layer (6) for the columns (Sp), each individual surface element (8) of a column (Sp) being greater than each individual surface element (7) of a row (Ze) by a factor in the range of from 1.1 to 1.5.

2. Operating device (1) according to claim 1, wherein the surface elements (7, 8) formed in the conductive layers (5, 6) are designed to bring about a change in an electrical variable, such as electrical resistance or capacitance, when the panel (3) is touched or approached.

3. Operating device (1) according to claim 1, wherein the spacing (A) has a width in the range of from 0.02 to 1 mm.

4. Operating device (1) according to any of claims 1 to 3, wherein a conductive surface element (7) of a row (Ze) has a size in the range of from 30 to 45 mm² and a conductive surface element (8) of a column (Sp) has a size in the range of from 45 to 55 mm².

5. Operating device (1) according to any of claims 1 to 4, wherein the surface elements (7) of the first layer (5) are curved approximately in the shape of a mirrored tulip, and in that the surface elements (8) of the second layer (6) are approximately shaped as a mirrored heart, corresponding to the curvatures of the first layer (5).

6. Operating device (1) according to any of claims 1 to 5, **characterised in that** the panel (3) is made of glass or a transparent plastics material.

7. Water-conducting domestic appliance (2), such as a washing machine, dryer, washer-dryer or dishwasher, having a housing (17) comprising an operating device (1) according to any of claims 1 to 6.

8. Water-conducting domestic appliance (2) according to claim 7, **characterised in that** the panel (3) is formed as part of the housing (17).

9. Kitchen appliance, such as a cooker, oven or refrigerator, comprising an operating device (1) according to any of claims 1 to 6.

10. Cooker according to claim 9, comprising a glass plate or a ceramic glass cooktop, wherein the panel part (3) is formed by a region of the glass plate or of the ceramic glass cooktop.

## Revendications

1. Dispositif de commande (1) pour un appareil électroménager (2), qui comprend un bandeau (3) constitué en tant qu'écran tactile, avec un affichage, un champ de capteur (4) transparent avec une première couche (5) conductrice ayant une structure de lignes (Ze) au moins essentiellement rectilignes qui comprennent respectivement plusieurs éléments de surface (7) raccordés entre eux de façon conductrice, et avec une deuxième couche (6) conductrice ayant une structure de colonnes (Sp) au moins essentiellement rectilignes qui s'étendent transversalement aux lignes (Ze) de la première couche (5), avec respectivement plusieurs éléments de surface (8) raccordés entre eux de façon conductrice, dans lequel, sur les différentes lignes et colonnes (Ze, Sp), il est attaché, sur au moins un bord (4a) du champ de capteur (4), des lignes (9) destinées au raccordement à un microcontrôleur pour la détermination d'une position de contact sur le bandeau (3), dans lequel la structure des lignes (Ze) et la structure des colonnes (Sp) des deux couches (5, 6) superposées sont constituées de telle sorte que les éléments de surface (7) de la première couche (5) sont situés dans la direction des couches (5, 6) près des éléments de surface (8) de la deuxième couche (6), avec formation d'un écart (A) essentiellement régulier dans la direction des couches (5, 6) d'éléments de surface voisins les uns des autres,
**caractérisé en ce que**
les différents éléments de surface (7) présentent respectivement une forme de base (7b) carrée ou en losange avec des lignes latérales (7c) de la bordure courbes constituées en forme de S, dans lequel les éléments de surface (8) de la deuxième couche (6) présentent respectivement la forme d'un coeur en miroir dont les pointes (8a) sont dans la direction d'étendue des colonnes (Sp), et les éléments de surface (7) de la première couche (5) présentent une forme de tulipe en miroir dont les côtés de tige (7a) sont dans la direction d'étendue des lignes (Ze), et
**en ce que** les éléments de surface (7), disposés en lignes, de la couche (5) qui est plus près du bandeau (3) sont plus petits que les éléments de surface (8) de la couche (6) pour les colonnes (Sp) située plus bas, dans lequel un élément de surface (8) individuel d'une colonne (Sp) est plus grand, selon un facteur dans la plage de 1,1 à 1,5, qu'un élément de surface (7) individuel d'une ligne (Ze).

2. Dispositif de commande (1) selon la revendication 1, dans lequel les éléments de surface (7, 8) constitués dans les couches (5, 6) conductrices sont constitués pour provoquer une variation d'une grandeur électrique telle que la résistance électrique ou la capacité en cas de contact avec ou d'approche du bandeau (3).

3. Dispositif de commande (1) selon la revendication 1, dans lequel l'écart (A) présente une largeur dans la plage de 0,02 à 1 mm.

4. Dispositif de commande (1) selon l'une des revendications 1 à 3, dans lequel un élément de surface (7) conducteur d'une ligne (Ze) présente une dimension dans la plage de 30 à 45 mm², et un élément de surface (8) conducteur d'une colonne (Sp) présente une dimension dans la plage de 45 à 55 mm².

5. Dispositif de commande (1) selon l'une des revendications 1 à 4, dans lequel les éléments de surface (7) de la première couche (5) sont constitués de façon courbe à peu près sous la forme d'une tulipe en miroir, et en ce que les éléments de surface (8) de la deuxième couche (6) sont constitués d'une façon correspondant aux courbures de la première couche (5) à peu près sous la forme d'un coeur en miroir.

6. Dispositif de commande (1) selon l'une des revendications 1 à 5, **caractérisé en ce que** le bandeau (3) se compose de verre ou d'une matière plastique transparente.

7. Appareil électroménager (2) conduisant de l'eau, tel que machine à laver, sécheur, laveur-sécheur ou lave-vaisselle, avec un carter (17) avec un dispositif de commande (1) selon l'une des revendications 1 à 6.

8. Appareil électroménager (2) conduisant de l'eau selon la revendication 7, **caractérisé en ce que** le bandeau (3) est constitué en tant que partie du carter (17).

9. Appareil de cuisine, tel que cuisinière, four ou réfrigérateur, avec un dispositif de commande (1) selon l'une des revendications 1 à 6.

10. Cuisinière selon la revendication 9, comprenant une plaque de verre ou une plaque vitrocéramique, dans laquelle la partie de bandeau (3) est formée d'une zone de la plaque de verre ou de la plaque vitrocéramique.
